# EUROPEAN PATENT SPECIFICATION

(11) **EP 4 486 073 B1**
(45) Date of publication and mention of the grant of the patent: **03.06.2026**
(21) Application number: 23216676.9
(22) Date of filing: 14.12.2023
(51) Int. Cl.: H05K 1/02, H05K 1/14, H05K 3/36, G06F 1/18, G06F 1/26, H05K 3/34

(54) **HIGH VOLTAGE POWER TRANSFER ON PRINTED CIRCUIT BOARD**
HOCHSPANNUNGSLEISTUNGSÜBERTRAGUNG AUF EINER LEITERPLATTE
TRANSFERT DE PUISSANCE HAUTE TENSION SUR CARTE DE CIRCUIT IMPRIMÉ

(30) Priority: 29.06.2023 US 202318343770
(43) Date of publication of application: 01.01.2025
(73) Proprietor: Intel Corporation, Santa Clara, CA 95054 (US)
(72) Inventor: AYUBKHAN, Ajmeer Kaja, 560017 Bangalore (IN); JANGILI GANGA, Siva Prasad, Bengaluru (IN); GUDIGOPURAM, Bharath Reddy, 508001 Nalgonda, Telangana (IN)
(74) Representative: Viering, Jentschura & Partner mbB Patent- und Rechtsanwälte

(56) References cited:
- WO-A1-2020/214150
- US-A1- 2014 268 615

## Description

### TECHNICAL FIELD

The present application relates to devices and methods as set out in the appended set of claims, generally to power delivery systems for electronic devices.

### BACKGROUND

Conventional printed circuit boards (PCB) operate using low voltages, which draw a lot of current for a certain amount of power. This in turn increases power loss and many planes are required to reduce the resistance, which leads to an increase in the number of PCB planes.

There is a need to reduce the power loss on PCB as well as reduced the number of planes required.

WO 2020214150 A1 discloses a processor that may be coupled to a first printed circuit board (PCB) by a first solder joint. The first PCB may be secured to a second PCB via a second solder joint. The melting temperature of the first solder joint may be higher than the melting temperature of the second solder joint. The first PCB may include a voltage regulator to receive input power from the second PCB and provide output power to the processor.

US 2014268615 A1 discloses a two-stage power delivery network including a voltage regulator and an interposer. The interposer includes a packaging substrate having an embedded inductor. The embedded inductor includes a set of traces and a set of through substrate vias at opposing ends of the traces. The interposer is coupled to the voltage regulator. The two-stage power delivery network also includes a semiconductor die supported by the packaging substrate. The two-stage power delivery network also includes a capacitor that is supported by the packaging substrate. The capacitor is operable to provide a decoupling capacitance associated with the semiconductor die and a capacitance to reduce a switching noise of the voltage regulator.

### BRIEF DESCRIPTION OF THE DRAWINGS

In the drawings, like reference characters generally refer to the same parts throughout the different views. The drawings are not necessarily to scale, emphasis instead generally being placed upon illustrating the principles of the present disclosure. The dimensions of the various features or elements may be arbitrarily expanded or reduced for clarity. In the following description, various aspects of the present disclosure are described with reference to the following drawings, in which:
FIG. 1 shows a cross-sectional view of a semiconductor device according to an aspect of the present disclosure;
FIG. 2 shows a flow chart illustrating a method of forming a semiconductor device according to an aspect of the present disclosure;
FIG. 3 shows a power loss table of a semiconductor device according to an aspect of the present disclosure; and
FIG. 4 shows an illustration of a computing device that includes a semiconductor device according to a further aspect of the present disclosure.

### SUMMARY

The summary of the invention pursued in the present application is set out in the appended set of claims.

### DETAILED DESCRIPTION

The following detailed description refers to the accompanying drawings that show, by way of illustration, specific details, and aspects in which the present disclosure may be practiced. These aspects are described in sufficient detail to enable those skilled in the art to practice the present disclosure. Various aspects are provided for the present devices, and various aspects are provided for the methods. It will be understood that the basic properties of the devices also hold for the methods and vice versa. Other aspects may be utilized and structural, and logical changes may be made without departing from the scope of the present disclosure.

An advantage of the present disclosure may include reduced complexity of the PCB as the high power voltage regulator is removed on the PCB for the high current rails and is placed on the package substrate instead. Power is routed to the high-power voltage regulator before being routed to the base die and the top die. This minimizes power loss, and minimizes the number of layers or routing lengths on the PCB to meet the same performance. Further, the heat sink design on the PCB will be simpler, and capacitors on the PCB can be removed or reduced, which reduces the cost and complexity of the PCB.

These and other aforementioned advantages and features of the aspects herein disclosed will be apparent through reference to the following description and the accompanying drawings. Furthermore, it is to be understood that the features of the various aspects described herein are not mutually exclusive and can exist in various combinations and permutations.

The present disclosure generally relates to a device. The device may include a printed circuit board. The device may also include a package substrate disposed on the printed circuit board. The device may also include a plurality of high-power voltage regulators disposed on and electrically connected to the package substrate. The device may also include a plurality of low-power voltage regulators disposed on and electrically connected to the printed circuit board. There may be 5-10 low-power voltage regulators disposed on and electrically connected to the printed circuit board.

The present disclosure generally relates to a method of forming a device. The method may include providing a printed circuit board. The method may also include disposing a package substrate on the printed circuit board. The method may also include disposing and electrically connecting a plurality of high-power voltage regulators to the package substrate. The method may also include disposing and electrically connecting a plurality of low-power voltage regulators to the printed circuit board. There may be 5-10 high-power voltage regulators disposed on and electrically connected to the printed circuit board.

To more readily understand and put into practical effect, the present device, method, and other particular aspects will now be described by way of examples and not limitations, and with reference to the figures. For the sake of brevity, duplicate descriptions of features and properties may be omitted.

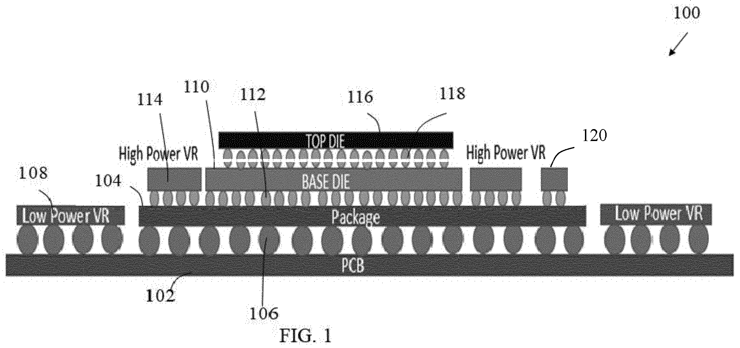

FIG. 1 shows a cross-sectional view of a semiconductor device according to an aspect of the present disclosure.

In an aspect of the present disclosure, a semiconductor device 100 is shown in FIG. 1. The semiconductor device 100 may be a stacked semiconductor package like a 2.5D or a 3D semiconductor package.

In an aspect of the present disclosure, the semiconductor device 100 may include a printed circuit board (PCB) 102. The printed circuit board 102 may be a motherboard.

In an aspect of the present disclosure, the semiconductor device 100 may include a package substrate 104. The package substrate 104 may include contact pads, electrical interconnects, routings, and other features, which are not shown in any of the present figures. The package substrate 104 may have one or more rigid core layers for improved structural stability or a coreless substrate package for a reduced form factor. In other aspects, the package substrate 104 may be part of a larger substrate that supports additional semiconductor packages, and/or components.

In an aspect of the present disclosure, the semiconductor device 100 may include a plurality of solder balls 106. In an aspect, the plurality of solder balls 106 may be disposed on a bottom surface of the package substrate 104. The package substrate 104 may be disposed on and electrically connected to the printed circuit board 102 through the plurality of solder balls 106. In an aspect, the plurality of solder balls 106 may provide an electrical connection between the package substrate 104, and the printed circuit board 102.

In an aspect of the present disclosure, the semiconductor device 100 may include a plurality of low power voltage regulators (VR) 108. The plurality of low power voltage regulators 108 may be disposed on and electrically connected to the printed circuit board 102 through the plurality of solder balls 106. In an aspect, the plurality of low power voltage regulators 108 is positioned adjacent to the package substrate 104. Each low power voltage regulator of the plurality of low power voltage regulators 108 may operate between 0.6V to 3.3V.

In an aspect of the present disclosure, the semiconductor device 100 may include a base die 110. In an aspect, the base die 110 may be made from any suitable semiconductor, such as silicon or gallium arsenide. The base die 110 may be a semiconductor die, a chip, or a set of chiplets, e.g., a system-on-chip (SOC), a platform controller hub (PCH)/chipset, a memory device, a field programmable gate array (FPGA) device, a central processing unit (CPU), or a graphic processing unit (GPU).

In an aspect of the present disclosure, the semiconductor device 100 may include a plurality of package bumps 112. The plurality of package bumps 112 may be disposed between the package substrate 104 and the base die 110. In an aspect, the plurality of package bumps 112 may facilitate an electrical connection between the base die 110 and the package substrate 104.

In an aspect of the present disclosure, the semiconductor device 100 may include a plurality of high power voltage regulators (VR) 114. The plurality of high-power voltage regulators 114 may be disposed on and electrically connected to the package substrate 104 through the plurality of package bumps 112. In an aspect, the plurality of high-power voltage regulators 114 is positioned adjacent to the base die 110. Each high power voltage regulator of the plurality of high-power voltage regulators 114 may operate between 3.3V to 20V.

In an aspect of the present disclosure, each high-power voltage regulator of the plurality of high-power voltage regulators may be a first size and may have a first switching frequency.

In an aspect of the present disclosure, each low-power voltage regulator of the plurality of low-power voltage regulators may be a second size and may have a second switching frequency. In an aspect of the present disclosure, the first size may be smaller than the second size. In an aspect of the present disclosure, the first switching frequency of each high-power voltage regulator is higher than the second switching frequency of each low-power voltage regulator. In an aspect of the present disclosure, the size of a voltage regulator can be reduced by increasing the operating frequency of the voltage regulator.

In an aspect, the GPU and CPU suffer huge amounts of power loss on the PCB 102 as the current drawn by core rails is very high. This can be addressed by reducing the current drawn from the PCB 102 to lower values by increasing the operating voltage of the rail to a higher value for the same amount of power consumption. In an aspect, the conventional voltage regulator for the high current rails on the PCB 102 is removed and the PCB 102 operates at the input voltage without any buck operation. The buck operation is carried out on the package substrate 104 by placing the high power voltage regulator on the package substrate 104 instead. To reduce the power loss on PCB 102, the power is supplied to package substrate 104 at a high voltage (e.g., 20V), which reduces the current requirement from the PCB 102 for the same amount of power consumed by the chip, and the voltage conversion is done on the package by placing a high-power voltage regulator on the package substrate 104. This reduces the power loss, heat dissipation, and the number of capacitors on the PCB.

In an aspect of the present disclosure, the printed circuit board 102 operates at an input voltage. In an aspect of the present disclosure, a bucking operation is conducted by the plurality of high-power voltage regulator 114 on the package substrate 104.

In an aspect of the present disclosure, the semiconductor device 100 may include a capacitor 120 disposed on the package substrate to control a ripple voltage of the package substrate. The capacitor 120 may be disposed adjacent to the plurality of high power voltage regulators 114.

In an aspect of the present disclosure, the semiconductor device 100 may include a top die 116. In an aspect, the top die 116 may be made from any suitable semiconductor, such as silicon or gallium arsenide. The top die 116 may be a semiconductor die, a chip, or a set of chiplets, e.g., a system-on-chip (SOC), a platform controller hub (PCH)/chipset, a memory device, a field programmable gate array (FPGA) device, a central processing unit (CPU), or a graphic processing unit (GPU).

In an aspect of the present disclosure, the semiconductor device 100 may include a plurality of solder bumps 118. The plurality of solder bumps 118 may be disposed between the base die 110 and the top die 116. In an aspect, the plurality of solder bumps 118 may facilitate an electrical connection between the top die 116 and the base die 110.

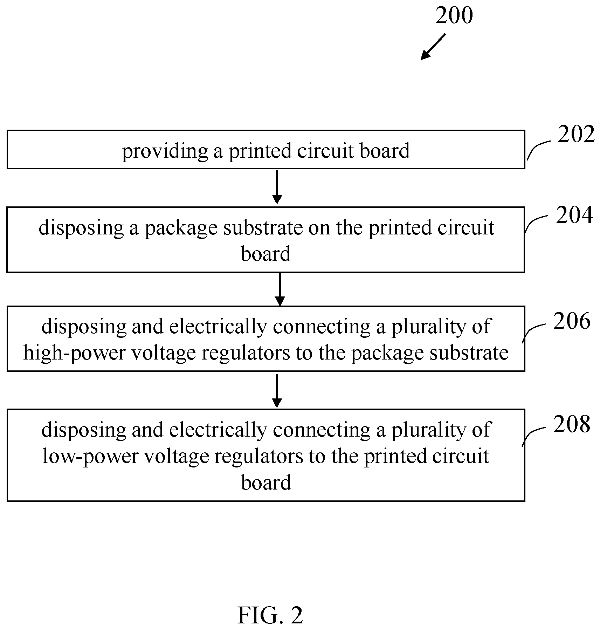

FIG. 2 shows a flow chart illustrating a method of forming a semiconductor device according to an aspect of the present disclosure.

As shown in FIG. 2, there may be a method 200 of forming a device. In the method 200, a first operation 202 may include providing a printed circuit board. A second operation 204 may include disposing a package substrate on the printed circuit board. A third operation 206 may include disposing and electrically connecting a plurality of high-power voltage regulators to the package substrate. A fourth operation 208 may include disposing and electrically connecting a plurality of low-power voltage regulators to the printed circuit board.

It will be understood that the above operations described above relating to FIG. 2 are not limited to this particular order. Any suitable, modified order of operations may be used.

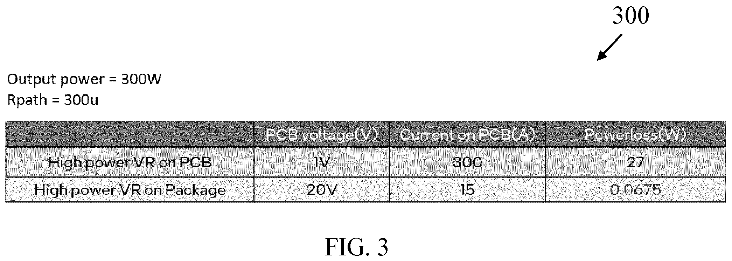

FIG. 3 shows a power loss table of a semiconductor device according to an aspect of the present disclosure.

In Table 300, when the output power is 300W and the resistance is 300u Ω, for conventional cases with high power VR on a PCB, the PCB voltage is 1V, the current on the PCB is 300A and the power loss is 27W. For an aspect disclosed herein, when the high power VR is on the package substrate instead of the PCB, the PCB voltage can be a high voltage such as 20V and the current on the PCB is 15 A for the same output power of 300W. Therefore, there is a significantly smaller power loss of 0.0675W compared to conventional cases.

Aspects of the present disclosure may be implemented into a system using any suitable hardware and/or software.

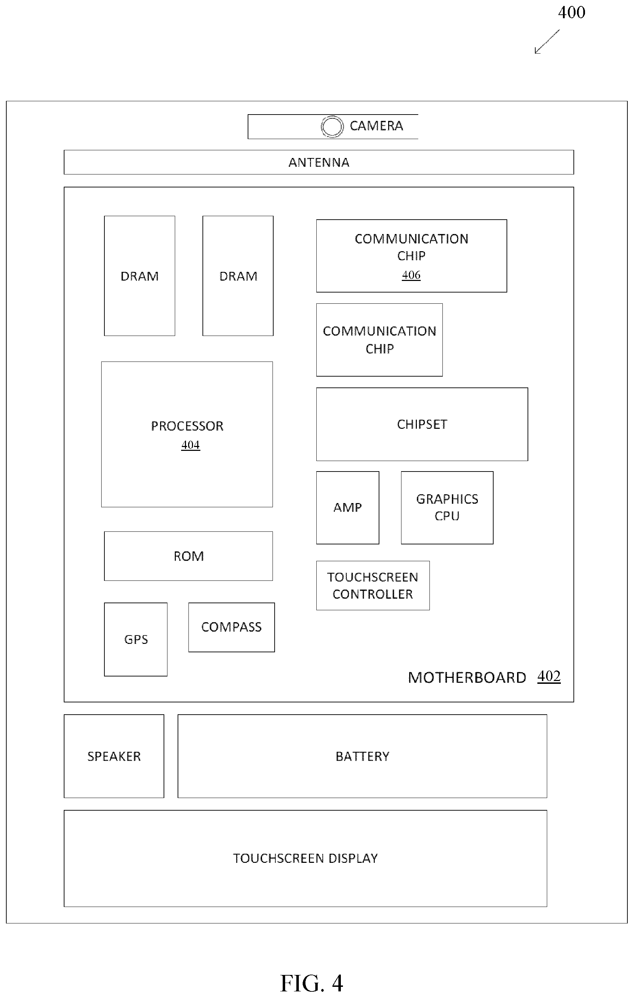

FIG. 4 schematically illustrates a computing device 400 that may include a semiconductor device as described herein, in accordance with some aspects.

As shown in FIG. 4, the computing device 400 may house a board such as a motherboard 402. The motherboard 402 may include a number of components, including but not limited to a processor 404 and at least one communication chip 406. The processor 404 may be physically and electrically coupled to the motherboard 402. In some implementations, the at least one communication chip 406 may also be physically and electrically coupled to the motherboard 402. In further implementations, the communication chip 406 may be part of the processor 404.

Depending on its applications, the computing device 400 may include other components that may or may not be physically and electrically coupled to the motherboard 402. These other components may include, but are not limited to, volatile memory (e.g., DRAM), nonvolatile memory (e.g., ROM), flash memory, a graphics processor, a digital signal processor, a crypto processor, a chipset, an antenna, a display, a touchscreen display, a touchscreen controller, a battery, an audio codec, a video codec, a power amplifier, a global positioning system (GPS) device, a compass, a Geiger counter, an accelerometer, a gyroscope, a speaker, a camera, and a mass storage device (such as hard disk drive, compact disk (CD), digital versatile disk (DVD), and so forth). In another aspect, the processor 404 of the computing device 400 may be packaged in a semiconductor package, as described herein, and/or other semiconductor devices may be packaged together in a semiconductor package as described herein.

The communication chip 406 may enable wireless communications for the transfer of data to and from the computing device 400. The term "wireless" and its derivatives may be used to describe circuits, devices, systems, methods, techniques, communications channels, etc., that may communicate data through the use of modulated electromagnetic radiation through a non-solid medium. The term does not imply that the associated devices do not contain any wires, although in some aspects they might not. The communication chip 406 may implement any of a number of wireless standards or protocols, including but not limited to Institute for Electrical and Electronics Engineers (IEEE) standards including Wi-Fi (IEEE 502.11 family), IEEE 502.16 standards (e.g., IEEE 502.16-2005 Amendment), Long-Term Evolution (LTE) project along with any amendments, updates, and/or revisions (e.g., advanced LTE project, ultra-mobile broadband (UMB) project (also referred to as "3GPP2"), etc.). IEEE 502.16 compatible BWA networks are generally referred to as WiMAX networks, an acronym that stands for Worldwide Interoperability for Microwave Access, which is a certification mark for products that pass conformity and interoperability tests for the IEEE 502.16 standards.

The communication chip 406 may also operate in accordance with a Global System for Mobile Communication (GSM), General Packet Radio Service (GPRS), Universal Mobile Telecommunications System (UMTS), High Speed Packet Access (HSPA), Evolved HSPA (E-HSPA), or LTE network. The communication chip 406 may operate in accordance with Enhanced Data for GSM Evolution (EDGE), GSM EDGE Radio Access Network (GERAN), Universal Terrestrial Radio Access Network (UTRAN), or Evolved UTRAN (E-UTRAN). The communication chip 406 may operate in accordance with Code Division Multiple Access (CDMA), Time Division Multiple Access (TDMA), Digital Enhanced Cordless Telecommunications (DECT), Evolution-Data Optimized (EV-DO), derivatives thereof, as well as any other wireless protocols that are designated as 3G, 4G, 5G, and beyond. The communication chip 406 may operate in accordance with other wireless protocols in other aspects.

The computing device 400 may include a plurality of communication chips 406. For instance, a first communication chip 406 may be dedicated to shorter range wireless communications such as Wi-Fi and Bluetooth, and a second communication chip 406 may be dedicated to longer range wireless communications such as GPS, EDGE, GPRS, CDMA, WiMAX, LTE, Ev-DO, and others.

In various implementations, the computing device 400 may be a laptop, a netbook, a notebook, an ultrabook, a smartphone, a tablet, a personal digital assistant (PDA), an ultra mobile PC, a mobile phone, a desktop computer, a server, a printer, a scanner, a monitor, a set-top box, an entertainment control unit, a digital camera, a portable music player, or a digital video recorder. In an aspect, the computing device 400 may be a mobile computing device. In further implementations, the computing device 400 may be any other electronic device that processes data.

These and other advantages and features of the aspects herein disclosed will be apparent through reference to the following description and the accompanying drawings. Furthermore, it is to be understood that the features of the various aspects described herein are not mutually exclusive and can exist in various combinations and permutations.

It will be understood that any property described herein for a specific system or device may also hold for any system or device described herein. It will also be understood that any property described herein for a specific method may hold for any of the methods described herein. Furthermore, it will be understood that for any device, system, or method described herein, not necessarily all the components or operations described will be enclosed in the device, system, or method, but only some (but not all) components or operations may be enclosed.

The term "comprising" shall be understood to have a broad meaning similar to the term "including" and will be understood to imply the inclusion of a stated integer or operation or group of integers or operations but not the exclusion of any other integer or operation or group of integers or operations. This definition also applies to variations on the term "comprising" such as "comprise" and "comprises".

The term "coupled" (or "connected") herein may be understood as electrically coupled or as mechanically coupled, e.g., attached or fixed or attached, or just in contact without any fixation, and it will be understood that both direct coupling or indirect coupling (in other words: coupling without direct contact) may be provided.

While the present disclosure has been particularly shown and described with reference to specific aspects, it should be understood by those skilled in the art that various changes in form and detail may be made therein without departing from the scope of the present disclosure as defined by the appended claims. The scope of the present disclosure is thus indicated by the appended claims and all changes which come within the meaning and range of equivalency of the claims are therefore intended to be embraced.

## Claims

1. A device comprising:
a printed circuit board (102);
a package substrate (104) disposed on the printed circuit board (102);
a plurality of high-power voltage regulators (114) disposed on and electrically connected to the package substrate (104); and
a plurality of low-power voltage regulators (108) disposed on and electrically connected to the printed circuit board (102),
wherein the printed circuit board is configured to operate at an input voltage, and wherein the plurality of high-power voltage regulators are configured to receive the input voltage from the printed circuit board and conduct a bucking operation on the package substrate,
wherein a first size of each high-power voltage regulator of the plurality of high-power voltage regulators is smaller than a second size of each low-power voltage regulator of the plurality of low-power voltage regulators, and
wherein a first switching frequency of each high-power voltage regulator is higher than a second switching frequency of each low-power voltage regulator.

2. The device of claim 1, further comprising a capacitor (120) disposed on the package substrate (104) to control a ripple voltage of the package substrate (104).

3. The device of any one of claims 1 or 2, further comprising a base die (110) disposed on the package substrate (104), wherein the plurality of high-power voltage regulators (114) is positioned adjacent to the base die (110) and configured to provide a power source for the base die (110).

4. The device of any one of claims 1 to 3, wherein the plurality of low-power voltage regulators (108) is positioned adjacent to the package substrate (104).

5. A method comprising:
providing a printed circuit board (102) to operate at an input voltage;
disposing a package substrate (104) on the printed circuit board (102);
disposing and electrically connecting a plurality of high-power voltage regulators (114) to the package substrate (104), such that the plurality of high-power voltage regulators (114) are configured to receive the input voltage from the printed circuit board (102) and to conduct a bucking operation on the package substrate; and
disposing and electrically connecting a plurality of low-power voltage regulators (108) to the printed circuit board (102),
wherein a first size of each high-power voltage regulator of the plurality of high-power voltage regulators (114) is smaller than a second size of each low-power voltage regulator of the plurality of low-power voltage regulators (108); and a first switching frequency of each high-power voltage regulator is higher than a second switching frequency of each low-power voltage regulator.

6. The method of claim 5, further comprising disposing a capacitor (120) on the package substrate (104) to control a ripple voltage of the package substrate (104).

7. The method of any one of claims 5 to 6, further comprising disposing a base die (110) on the package substrate (104), wherein the plurality of high-power voltage regulators (114) is positioned adjacent to the base die (110).

## Patentansprüche

1. Vorrichtung, umfassend:
eine Leiterplatte (102);
ein Gehäusesubstrat (104), das auf der Leiterplatte (102) angeordnet ist;
mehrere Hochleistungs-Spannungsregler (114), die auf dem Gehäusesubstrat (104) angeordnet und elektrisch mit diesem verbunden sind; und
mehrere Niederleistungs-Spannungsregler (108), die auf der Leiterplatte (102) angeordnet und elektrisch mit dieser verbunden sind,
wobei die Leiterplatte dazu ausgelegt ist, mit einer Eingangsspannung zu arbeiten, und wobei die mehreren Hochleistungs-Spannungsregler dazu ausgelegt sind, die Eingangsspannung von der Leiterplatte zu empfangen und eine Abwärtswandlung auf dem Gehäusesubstrat durchzuführen,
wobei eine erste Größe jedes Hochleistungs-Spannungsreglers der mehreren Hochleistungs-Spannungsregler kleiner als eine zweite Größe jedes Niederleistungs-Spannungsreglers der mehreren Niederleistungs-Spannungsregler ist, und
wobei eine erste Schaltfrequenz jedes Hochleistungs-Spannungsreglers höher als eine zweite Schaltfrequenz jedes Niederleistungs-Spannungsreglers ist.

2. Vorrichtung nach Anspruch 1, ferner umfassend einen Kondensator (120), der auf dem Gehäusesubstrat (104) angeordnet ist, um eine Restwelligkeitsspannung des Gehäusesubstrats (104) zu steuern.

3. Vorrichtung nach einem der Ansprüche 1 oder 2, ferner umfassend ein Basis-Die (110), das auf dem Gehäusesubstrat (104) angeordnet ist, wobei die mehreren Hochleistungs-Spannungsregler (114) angrenzend an das Basis-Die (110) positioniert und dazu ausgelegt sind, eine Leistungsquelle für das Basis-Die (110) bereitzustellen.

4. Vorrichtung nach einem der Ansprüche 1 bis 3, wobei die mehreren Niederleistungs-Spannungsregler (108) angrenzend an das Gehäusesubstrat (104) positioniert sind.

5. Verfahren, umfassend:
Bereitstellen einer Leiterplatte (102), um mit einer Eingangsspannung zu arbeiten;
Anordnen eines Gehäusesubstrats (104) auf der Leiterplatte (102);
Anordnen und elektrisches Verbinden mehrerer Hochleistungs-Spannungsregler (114) mit dem Gehäusesubstrat (104), so dass die mehreren Hochleistungs-Spannungsregler (114) dazu ausgelegt sind,
die Eingangsspannung von der Leiterplatte (102) zu empfangen und eine Abwärtswandlung auf dem Gehäusesubstrat durchzuführen; und
Anordnen und elektrisches Verbinden mehrerer Niederleistungs-Spannungsregler (108) mit der Leiterplatte (102),
wobei eine erste Größe jedes Hochleistungs-Spannungsreglers der mehreren Hochleistungs-Spannungsregler (114) kleiner als eine zweite Größe jedes Niederleistungs-Spannungsreglers der mehreren Niederleistungs-Spannungsregler (108) ist; und wobei eine erste Schaltfrequenz jedes Hochleistungs-Spannungsreglers höher als eine zweite Schaltfrequenz jedes Niederleistungs-Spannungsreglers ist.

6. Verfahren nach Anspruch 5, ferner umfassend Anordnen eines Kondensators (120) auf dem Gehäusesubstrat (104), um eine Restwelligkeitsspannung des Gehäusesubstrats (104) zu steuern.

7. Verfahren nach einem der Ansprüche 5 bis 6, ferner umfassend Anordnen eines Basis-Die (110) auf dem Gehäusesubstrat (104), wobei die mehreren Hochleistungs-Spannungsregler (114) angrenzend an das Basis-Die (110) positioniert sind.

## Revendications

1. Dispositif comprenant :
une carte de circuit imprimé (102) ;
un substrat de boîtier (104) disposé sur la carte de circuit imprimé (102) ;
une pluralité de régulateurs de tension haute puissance (114) disposés sur et connectés électriquement au substrat de boîtier (104) ; et
une pluralité de régulateurs de tension basse puissance (108) disposés sur et connectés électriquement à la carte de circuit imprimé (102),
la carte de circuit imprimé étant configurée pour fonctionner à une tension d'entrée, et la pluralité de régulateurs de tension haute puissance étant configurés pour recevoir la tension d'entrée provenant de la carte de circuit imprimé et conduire une opération d'abaissement de tension sur le substrat de boîtier,
une première taille de chaque régulateur de tension haute puissance de la pluralité de régulateurs de tension haute puissance étant inférieure à une deuxième taille de chaque régulateur de tension basse puissance de la pluralité de régulateurs de tension basse puissance, et
une première fréquence de commutation de chaque régulateur de tension haute puissance étant supérieure à une deuxième fréquence de commutation de chaque régulateur de tension basse puissance.

2. Dispositif selon la revendication 1, comprenant en outre un condensateur (120) disposé sur le substrat de boîtier (104) pour commander une tension d'ondulation du substrat de boîtier (104).

3. Dispositif selon l'une quelconque des revendications 1 ou 2, comprenant en outre un dé de base (110) disposé sur le substrat de boîtier (104), la pluralité de régulateurs de tension haute puissance (114) étant positionnée de manière adjacente au dé de base (110) et configurée pour fournir une source d'alimentation pour le dé de base (110).

4. Dispositif selon l'une quelconque des revendications 1 à 3, dans lequel la pluralité de régulateurs de tension basse puissance (108) est positionnée de manière adjacente au substrat de boîtier (104).

5. Procédé comprenant :
la fourniture d'une carte de circuit imprimé (102) pour fonctionner à une tension d'entrée ;
la disposition d'un substrat de boîtier (104) sur la carte de circuit imprimé (102) ;
la disposition et la connexion électrique d'une pluralité de régulateurs de tension haute puissance (114) au substrat de boîtier (104), de telle sorte que la pluralité de régulateurs de tension haute puissance (114) est configurée pour recevoir la tension d'entrée en provenance de la carte de circuit imprimé (102) et pour conduire une opération d'abaissement de tension sur le substrat de boîtier ; et
la disposition et la connexion électrique d'une pluralité de régulateurs de tension basse puissance (108) à la carte de circuit imprimé (102),
une première taille de chaque régulateur de tension haute puissance de la pluralité de régulateurs de tension haute puissance (114) étant inférieure à une deuxième taille de chaque régulateur de tension basse puissance de la pluralité de régulateurs de tension basse puissance (108) ; et une première fréquence de commutation de chaque régulateur de tension haute puissance étant supérieure à une deuxième fréquence de commutation de chaque régulateur de tension basse puissance.

6. Procédé selon la revendication 5, comprenant en outre la disposition d'un condensateur (120) sur le substrat de boîtier (104) pour commander une tension d'ondulation du substrat de boîtier (104).

7. Procédé selon l'une quelconque des revendications 5 à 6, comprenant en outre la disposition d'un dé de base (110) sur le substrat de boîtier (104), la pluralité de régulateurs de tension haute puissance (114) étant positionnée de manière adjacente au dé de base (110).
